# EUROPEAN PATENT SPECIFICATION

(11) **EP 0 276 684 B1**
(45) Date of publication and mention of the grant of the patent: **24.03.1993**
(21) Application number: 88100333.9
(22) Date of filing: 12.01.1988
(51) Int. Cl.: H01F 41/04

(54) **Foil-roll electronic part and process of producing same**
Elektronisches Bauelement mit Rollenfolie und sein Herstellungsverfahren
Composant électronique à feuille enroulée et son procédé de fabrication

(30) Priority: 14.01.1987 JP 4967/87; 07.01.1988 JP 1744/88
(43) Date of publication of application: 03.08.1988
(73) Proprietor: Ikeda, Takeshi, Ohta-Ku Tokyo 143 (JP)
(72) Inventor: Ikeda, Takeshi, Ohta-Ku Tokyo 143 (JP)
(74) Representative: Weber, Otto Ernst, Dipl.-Phys.

(56) References cited:
- DE-A- 2 950 201
- FR-A- 2 335 922
- US-A- 2 706 280
- US-A- 3 067 497

## Description

### Field of the Invention

This invention relates to a foil-roll electronic part and a process of producing the same, and more particularly to a foil-roll electronic part formed by rolling in a belt-shaped conductive foil or foils and a process of producing the same.

### Description of the Prior Art

The inventor of the present invention has proposed a foil-roll electronic part wherein one or a plurality of belt-shaped conductive foils made of aluminum or copper are rolled on a magnetic or non-magnetic spool, or rolled on no core through insulating films of a high dielectric constant such as Mylar and polyethylene. This electronic part has an inductance wherein a stray capacitance is distributed over the total length of the belt-shaped conductor or conductors which has been rolled in or between the respective belt-shaped conductive foils. Owing to this characteristics, this electronic part can be used in the various fields as LC composite parts including a coil, a noise filter and a transformer.

This foil-roll electronic part utilizes a belt-shaped conductive foil or foils. Owing to this, an electric current of a relatively high value can be passed therethrough, a skin effect to a high frequency signal is minimal, the electronic part is compact in size, and yet, a high inductance and capacitance can be obtained. Due to the above-described reasons, this foil-roll electronic part has a possibility of being widely used for the various applications, and particularly, it is ascertained by the inventor that, in the noise filter, an outstanding attenuation characteristic can be obtained.

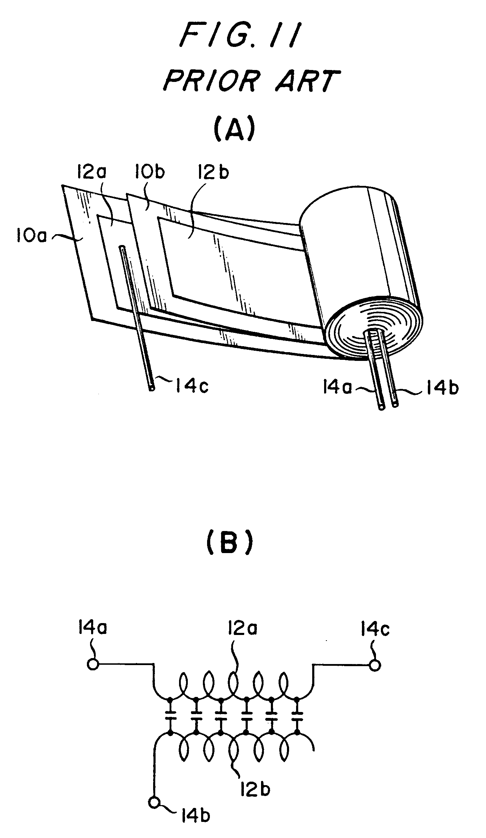

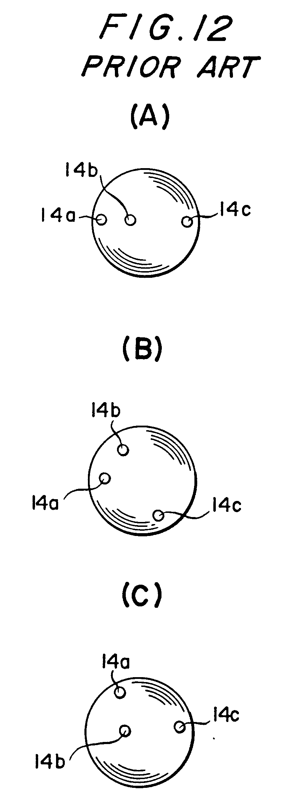

Various noise filters using the belt-shaped conductive foil or foils as described above have been proposed by the inventor of the present invention including the foil-roll electronic part of the kind defined by the precharacterizing features of claim 1, the manufacturing process of which, which is defined by the precharacterizing features of claim 11, shall be described along with Figs. 11A-B and 12A-C.

As shown in Fig. 11(A) for example, two of insulating films 10a and 10b which are formed of Mylar tapes and two belt-shaped conductive foils 12a and 12b which are formed of aluminum foils are alternately superposed on each other and rolled into a tubular shape. At this time, leads 14a and 14c are connected by electric welding or the like to a roll starting portion and a roll terminating portion of one 12a of the belt-shaped conductive foils, which is used as a conductor for passing electricity. Furthermore, a lead 14b for grounding is connected by the same method as above to one end portion, preferably, a roll starting portion of the other 12b of the belt-shaped conductive foils, which is used for a grounding conductor.

In the noise filter formed as described above, an inductance is formed between the leads 14a and 14c of the belt-shaped conductive foil 12a for passing the electricity, and yet, an equally distributed capacitance is formed between the belt-shaped conductive foil 12c for grounding and the belt-shaped conductive foil 12a for passing the electricity over the total length of the conductor 12a. Fig. 11(B) shows an equivalent circuit diagram of the noise filter thus formed.

Accordingly, when the lead 14b for grounding is grounded and the leads 14a and 14c of the belt-shaped conductive foil 12a are used as input and output terminals, respectively, a noise filter having outstanding attenuation characteristics over a wide frequency band can be obtained.

Now, in the noise filter of the type described, it is required that the three leads 14a, 14b and 14c are arranged on a straight line at regular intervals as shown in Fig. 12(A).

If these leads 14a, 14b and 14c are arranged irregularly, then, particularly, the uniform attenuation characteristics and outstanding electric characteristics as in the noise filter cannot be obtained.

Further, these leads 14a, 14b and 14c should be arranged on the straight line at regular intervals, and yet, the lead arrangement should meet a hole pitch of a printed circuit board for being actually mounted thereon.

If this lead arrangement does not meet the hole pitch of the printed circuit board, then, the respective leads 14a, 14b and 14c cannot be inserted into the holes of the printed circuit board to mount the noise filter.

Normally, the foil-roll electronic part of the type described can be manufactured by use of a device analogous to a device for producing a paper capacitor.

However, if the above-described device is used, then, due to the values of the rollings being tightened in the condition of loosely rolled-up rollings at the time of roll-up, the arrangement of the three leads 14a, 14b and 14c is not definite and the respective leads tend to be shifted from one another as shown in Figs. 12(B) and 12(C). Because of this, it has been extremely difficult to roll up such that the respective leads are regularly arranged at all times.

Moreover, such problems have been presented that, after the roll-up, the irregularly arranged leads 14a, 14b and 14c should be corrected to have a regular pitch, whereby the productivity is low and the production thereof is not suitable for bulk production.

### SUMMARY OF THE INVENTION

The present invention has been developed to obviate the problems in the manufacture of the above-described foil-roll electronic part and has as its object the provision of a foil-roll electronic part of the kind defined by the precharacterizing features of claim 1 which can be accurately positioned at lead intervals, is suitable for bulk production, excellent in the electric characteristics and can be easily, actually mounted on a printed circuit board, and an advantageous process of producing the same of the kind defined by the precharacterizing features of claim 11.

This object is attained by the characterizing features of claim 1 concerning the product and by the characterizing features of claim 11 concerning the process.

### BRIEF DESCRIPTION OF THE DRAWINGS

Fig. 1 is an explanatory view showing a preferred example of the noise filter according to the present invention, Figs. 1(A)-1(J) illustrating steps in the manufacture of the noise filter;
Figs. 2 and 3 are explanatory views showing examples of modifications of the lead frame used in the present invention;
Figs. 4 are explanatory views of other examples of the noise filter according to the present invention, Fig. 4(A) being an explanatory view showing the regulating member portion, Fig. 4(B) being an explanatory view showing the lead frame portion and Fig. 4(C) being an explanatory view showing an example of a modification of the lead frame portion;
Fig. 5 is an explanatory view showing another example of the lead frame portion;
Figs. 6 are explanatory views of a balanced type noise filter according to the present invention, Fig. 6(A) being the equivalent circuit diagram and Fig. 6(B) being an explanatory view of the regulating member;
Figs. 7 are explanatory views of a split grounding type noise filter according to the present invention, Fig. 7(A) being the equivalent circuit diagram and Fig. 7(B) being an explanatory view of the lead frame;
Fig. 8 is an equivalent circuit diagram showing an example where a transformer having a primary and a secondary windings, which are independent from each other, is formed according to the present invention;
Fig. 9 is an equivalent circuit diagram showing an example of a coil having an intermediate tap and a transformer according to the present invention;
Figs. 10 are explanatory views of an example of the transformer according to the present invention, Fig. 10(A) being the equivalent circuit diagram thereof, Fig. 10(B) being an explanatory view showing the regulating member and Fig. 10(C) being an explanatory view showing a case where the circuit shown in Fig. 10(A) is grounded;
Figs. 11 are explanatory views of the conventional noise filter, Fig. 11(A) being an explanatory view showing the arrangement of the noise filter thereof and Fig. 11(B) being the equivalent circuit diagram of the conventional noise filter; and
Figs. 12 are explanatory views showing the leadsʹ portion of the foil-roll electronic part, Fig. 12(A) being an explanatory view showing the ideal arrangement of the leads and Figs. 12(B) and 12(C) being the explanatory views showing the conventional lead arrangements.

### DETAILED DESCRIPTION OF THE PREFERRED EMBODIMENTS

The preferred embodiments of the present invention will hereunder be described with reference to the accompanying drawings.

### The first embodiment

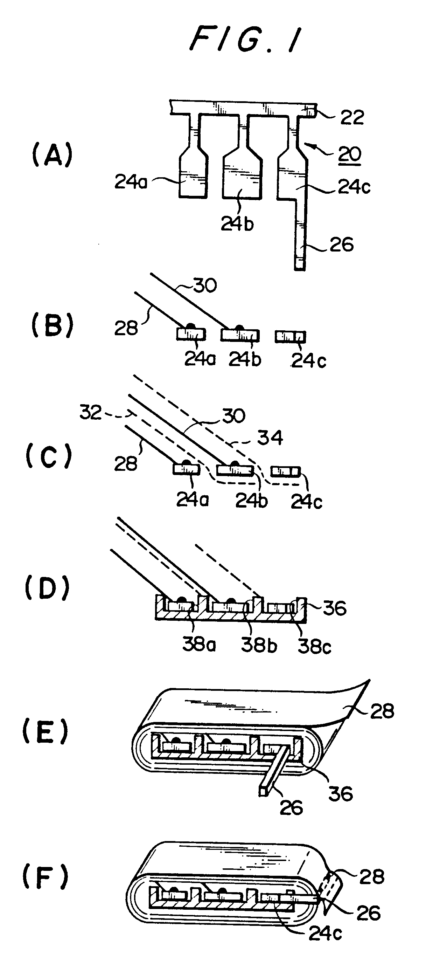

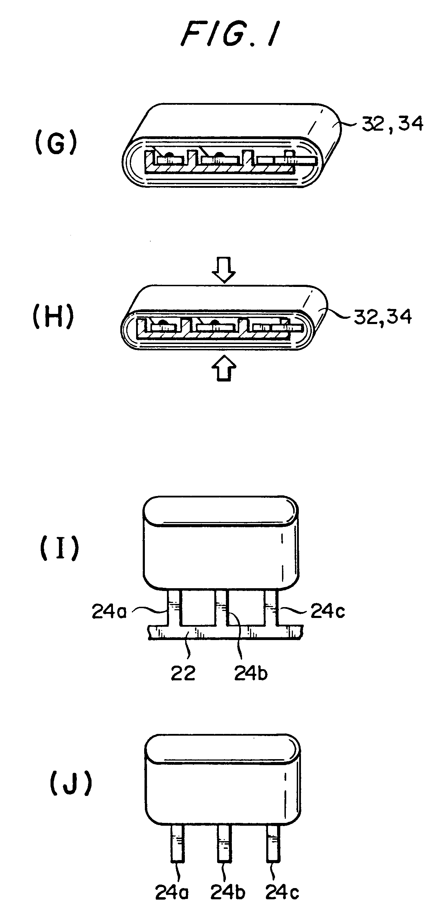

Figs. 1 shows a preferred example of a noise filter according to the present invention, Figs. 1(A)-1(J) illustrating steps in the manufacture of the noise filter.

Fig. 1(A) shows a lead frame 20 used in this embodiment. This lead frame 20 has at least three sheetshaped leads 24a, 24b and 24c, which are previously formed at regular intervals. In this embodiment, the lead frame is formed similarly to the lead frame used in packaging a semiconductor integrated circuit (IC). In this lead frame 20, the three leads 24a, 24b and 24c, which are generally in parallel to one another, are connected at ends on one side to one another through a connecting member 22.

Normally, the lead frame 20 of this type is formed by pressing a copper or a nickel alloy plate. Furthermore, this lead frame 20 as a whole is preferably plated by use of a solder or a highly conductive metal.

Referring to the drawing, in this lead frame 20, a bendable extension 26 is formed at one end of the lead 24c.

In this embodiment, by use of the lead frame 20 thus formed, first, a step shown in Fig. 1(B) is performed. In this step, a belt-shaped conductive foil 28 for passing the electricity and the belt-shaped conductive foil 30 for grounding are connected to the respective leads 24a and 24b. In this embodiment, first, a starting end of the belt-shaped conductive foil 28 to be a conductor for passing the electricity is welded to the lead 24a. Similarly, the starting end of the belt-shaped conductive foil 30 to be a conductor for grounding is welded to the lead 24b.

Subsequently, a step shown in Fig. 1(C) is performed. In this step, insulating films 32 and 34 formed of capaciter papers or Mylar tapes are interposed between the respective belt-shaped conductive foils 28 and 30.

Next, a step shown in Fig. 1(D) is performed. In this step, a regulating member 36 for holding the respective leads 24a-24c at regular intervals is positioned beneath the leads 24a, 24b and 24c. Then, the respective leads 24a-24c are coupled into grooves 38a-38c of this regulating member 36. The depth of the grooves 38 is determined to be slightly larger than the thickness of the lead 24.

Subsequently, a rolling step shown in Fig. 1(E) is performed. In this step, by use of the lead frame 20 coupled thereinto with a regulating member 14 as a spool, the belt-shaped conductive foils 28 and 30 are alternately superposed on each other with the insulating films being disposed therebetween and rolled by a predetermined number of times into a tubular shape with the conductive foils being held flat. At this time, the belt-shaped conductive foils 28 and 30 are rolled in by the number of times determined by the necessary values of inductance and capacitance.

Next, a step of treating a terminating end of the belt-shaped conductive foil 28 for passing the electricity as shown in Fig. 1(F) is performed. In this step, the extension 26 of the lead 24c is bent and connected by the welding or the like to the terminating end of the belt-shaped conductive foil 28 for passing the electricity, which has been rolled by the predetermined number in the step shown in Fig. 1(E).

Subsequently, a step of protectively covering as shown in Fig. 1(G) is performed. In this step, the insulating films 32 and 34 are further rolled in by a predetermined number of times to form a protective cover portion on the outermost peripheral portion.

Next, a step of pressing as shown in Fig. 1(H) is performed. This step is the step of pressing for safely guarding the characteristics, in which the rolled-in body is pressed in a heated state.

Subsequently, in a step shown in Fig. 1(I), a surface coating by use of epoxy resin or the like is performed for dusting and the like.

Next, a step of cutting off as shown in Fig. 1(J) is performed. In this step, the leads 24a-24c are cut off. More specifically, the respective leads 24a-24c are cut off the connecting member 22 of the lead frame 20. With this operation, a finished noise filter can be obtained.

As has been described hereinabove, in the noise filter in this embodiment, the lead frame 20, in which the leads 24a-24c are not changed in position, is used, so that the leads 24a-24c can be positioned accurately. Accordingly, it is not necessary to perform the lead position correcting treatment as in the conventional cases where the leads 14a-14c were used, and the respective leads 24a-24c can be arranged on the straight line and at the scheduled intervals. Accordingly, the present invention is suitable for the bulk production of the various foil-roll electronic parts such as the noise filters, and yet, the yield, the loss of which is caused by the leads 24, can be improved greatly.

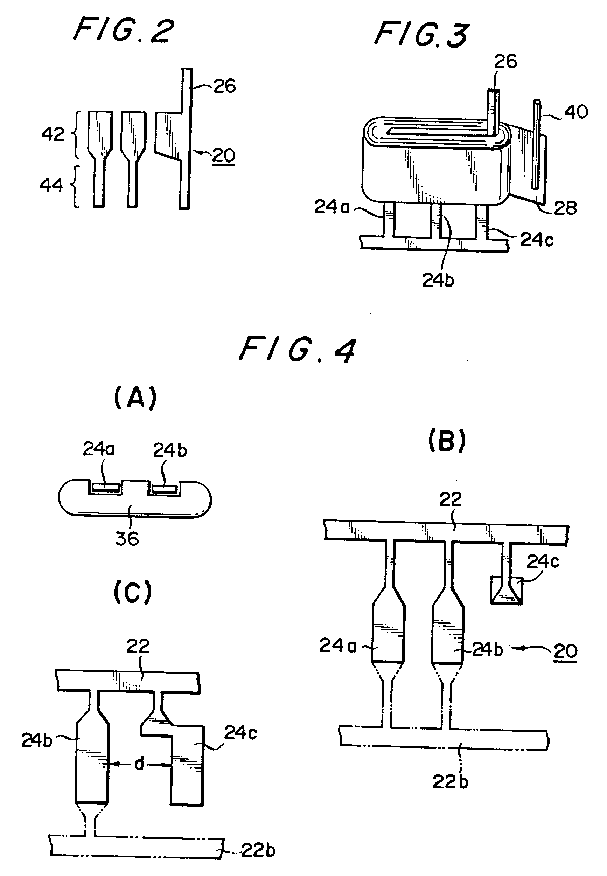

Further, the use of an integrated lead frame in the noise filter according to the present invention allows a portion 42 to function as a spool and to be selected to have a desirable shape, with a portion 44 to be the leads of the lead frame being constant in pitch as shown in Fig. 2. With this arrangement, the flatness of the noise filter can be freely selected, meeting desirable characteristics (capacitance and inductance).

Furthermore, in the present invention, as the regulating member 36, an insulating holder formed of a plastic molded item may be used for example. As the material for the regulating member 36, an insulating magnetic substance such as ferrite may be used and a magnetic material obtained by sintering magnetic particles together with a binder may be used. When the magnetic regulating member 36 is formed as described above, the belt-shaped conductive foil 28 for passing the electricity is increased in inductance, so that the noise arresting effect is improved, and, in the case of the same value of inductance, the noise filter can be rendered compact in size.

Further, when a magnetic conductor such as iron is used as the belt-shaped conductive foil, the inductance in a rolled coil is increased, so that the noise arresting effect can be improved.

Fig. 3 shows another example of the noise filter according to the present invention.

In this embodiment, an additional lead 40 is previously welded to the proximity of the terminating end of the belt-shaped conductive foil 28 for passing the electricity. Upon completion of the rolling step, this additional lead 40 and the extension 26 of the lead 24c are connected to each other by the welding or soldering.

Furthermore, Fig. 4 shows other examples of the regulating member 36 and the lead frame 20.

In this embodiment, the terminating end of the belt-shaped conductive foil 28 for passing the electricity and the lead 24c are connected to each other without using the aforesaid extension 26.

More specifically, in this embodiment, the lead frame 20 shown in Fig. 4(B) is prepared. In the step shown in Fig. 1(C), the lead 24c is previously bent through a suitable angle (90° for example) as compared with the other leads 24a and 24b, and the leads 24a and 24b of the lead frame 20 are coupled into the grooves 38 of the regulating member 36 (Since the lead 24c is bent, in the regulating member 36 used in this embodiment is formed with the grooves only for leads 24a and 24b as shown in Fig. 4(A).

After the belt-shaped conductive foils 28 and 30 and the insulating films 32 and 34 are rolled, in the step shown in Fig. 1(F), the bent lead 24c is returned to the substantially original position and connected to the terminating end of the belt-shaped conductive foil 28 for passing the electricity.

As described above, the leads 24a, 24b and 24c can be arranged generally on a straight line.

Furthermore, when the lead frame 20 shown in Fig. 4(B) is used, the noise filter can be formed without using the regulating member 36. In this case, as shown in Fig. 4(B), it is preferable that both end portions of the leads 24a and 24b are connected to each other through the connecting members 22 and 22b, so that, even if external forces are applied to the leads 24a and 24b, these leads 24a and 24b can remain underformed. Additionally, the lead 24c, which is bent for use, is connected only at one end thereof to the other leads 24a and 24b through the connecting member 22.

To form the noise filter by use of the leads 24 thus formed, for example, the lead 24c is bent through the predetermined angle in the step shown in Fig. 1(C), and thereafter, the belt-shaped conductive foils 28, 30 and the insulating films 32, 34 are rolled as shown in Fig. 1(E). Since the both ends of the leads 24a and 24b are connected to each other, even if a force is applied thereto more or less during the rolling work, these leads can remain underformed. Upon completion of this rolling step, the bent lead 24c is returned to the original position and connected to the terminating end of the belt-shaped conductive foil 28.

With this arrangement, the noise filter can be formed without using the regulating member 36, so that the cost of the noise filter per unit can be greatly reduced, and moreover, the thickness of the noise filter can be decreased by the thickness of the regulating member.

Furthermore, in order to bend the lead 24c as described above to form the noise filter, it is necessary to set a pitch interval d between the lead 24c and the lead 24b adjacent thereto at a suitable value in accordance with the number of turns of the belt-shaped conductive foils 28 and 30. In this case, as shown in Fig. 4(C), the lead 24c is curvedly formed, so that the pitch interval d from the lead 24b adjacent thereto can be set at a desirable value.

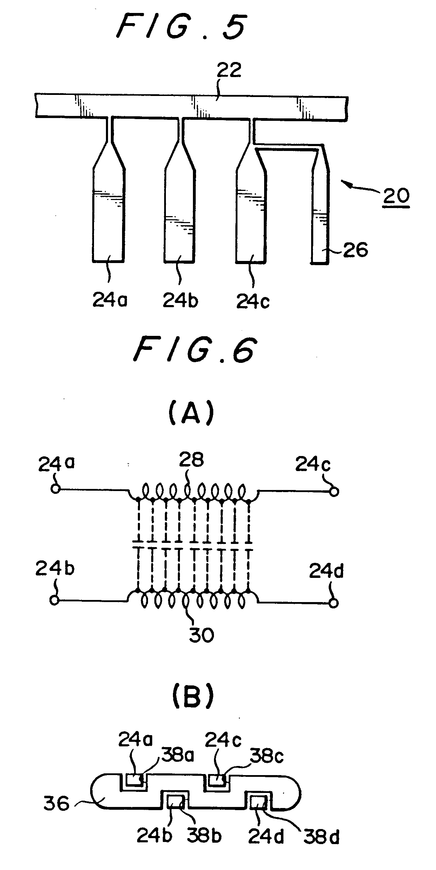

Furthermore, in this embodiment, the case where the extension 26 is provided at end portions on one end of the leads 24 is exemplified, however, the present invention need not necessarily be limited to this, the above-described extension 26 may be provided in parallel to the leads as shown in Fig. 5. In this case, the extension 26 for connecting to the terminating end of the belt-shaped conductive foil is previously bent through a suitable angle (90° for example) as compared with the leads 24, for example. And, upon rolling of the conductive foils and the insulating films, the extension 26 is returned to the substantially original position and connected to the conductor.

### The second embodiment

Figs. 6 show an example of the balance type noise filter according to the present invention, Fig. 6(A) showing the equivalent circuit diagram of this balance type noise filter and Fig. 6(B) showing the regulating member 30 for the leads.

The noise filter in this embodiment is constructed such that the leads 24a, 24b, 24c and 24d are connected to the starting ends and the terminating ends of the two belt-shaped conductive foils 28 and 30.

The leads 24a-24d may be coupled into grooves formed on one side surface of the regulating member 36. Furthermore, as shown in Fig. 6(B), the grooves 38 are formed on opposite side surfaces of the regulating member 36, the leads 24a and 24c of one 28 of the belt-shaped conductive foils may be coupled into grooves 38a and 38c, which are formed on one of the side surfaces, and the leads 24b and 24d of the other 30 of the belt-shaped conductive foils may be coupled into grooves 38b and 38d, which are formed on the other of the side surfaces. Additionally, the extensions 26 shown in Fig. 1(A) are provided on the leads 24c and 24d.

### The third embodiment

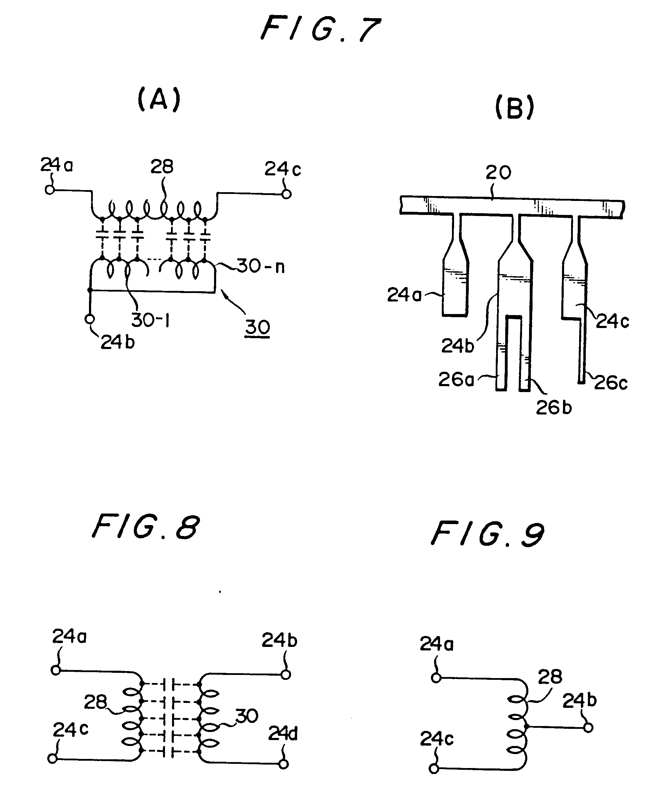

Figs. 7 show an example of the split grounding type noise filter according to the present invention.

The noise filter in this embodiment is so formed as to have the equivalent circuit diagram shown in Fig. 7(A). More specifically, in this embodiment, the beltshaped conductive foil 30 for grounding is n-divided into 30-1 ... 30-n. Referring to the drawing, there are shown two cases where the belt-shaped conductive foil 30 for grounding is divided. The conductive foils 30-1 ... 30-n thus divided are commonly connected to the lead 24b for grounding.

Fig. 7(B) shows an example of the lead frame 20 used in this noise filter. In this embodiment, a plurality of extensions 26a and 26b are provided on the lead 24b for grounding of this lead frame 20. Similarly, an extension 26c is provided on the lead 24c connected to the terminating end of the belt-shaped conductive foil 28 for passing the electricity.

The leads 26a and 26b which are provided on the lead 24b for grounding are connected to the split beltshaped conductive foils 30-1, 30-2 in association therewith. With this arrangement, the impedance to a point of grounding is decreased, so that the noise filter can be greatly improved in high frequency attenuation characteristics.

### The fourth embodiment

The foil-roll electronic parts according to the present invention can be widely used not only for the noise filters but also for other electronic parts.

Figs. 8 and 9 show examples where the foil-roll electronic parts according to the present invention are used in a transformer or a signal isolator.

More specifically, Fig. 8 shows an example of the transformer having the primary and secondary windings, which are independent of each other, and the construction thereof is identical with that of the noise filter shown in Fig. 6.

As apparent from this equivalent circuit diagram, the belt-shaped conductive foils 28 and 30 which are used as the primary and secondary wirings are magnetically, closely connected to each other, and moreover, capacitor-connected as well. Accordingly, the belt-shaped conductive foils 28 and 30 display highly stable signal transmitting characteristics over a wide band exceeding 100 MHz. Accordingly, when the foil-roll electronic part thus formed is used as shown in Fig. 8, it can be used as either a transformer or a signal connecting circuit between circuits different in potential from each other (isolator).

Fig. 9 shows examples of a coil with an intermediate tap and an auto-transformer, wherein a belt-shaped conductive foil 28 is rolled in through an insulating film. In this case also, the lead frame 20 is used, so that the leads 24a-24c can be lead-arranged on the straight line, and a transformer rendered compact in size and an inductor with an intermediate tap, which are high in yield, can be obtained. Furthermore, the part in this embodiment also uses the belt-shaped conductive foil 28, whereby this inductor is accompanied by relatively high parallel capacitances, so that the inductor can be used as an LC resonance circuit.

### The fifth embodiment

Furthermore, in the present invention, the rolled-in belt-shaped conductive foil may be actively used as a portion of a transformer core.

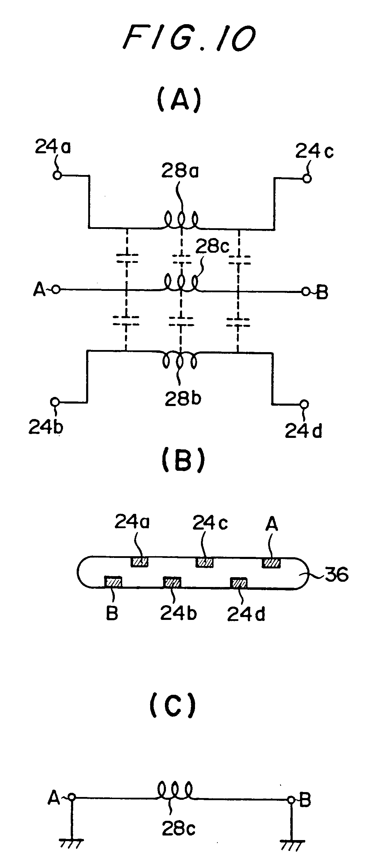

Fig. 10 shows an example of the transformer of this type.

This transformer is formed by rolling in at least three belt-shaped conductive foils 28a, 28b and 28c through insulating films. And, one 28c of the belt-shaped conductive foils is used as a portion of the transformer core, and the other two 28a and 28b of the belt-shaped conductive foils are used as a coil on the primary side of the transformer and a coil on the secondary side, respectively. Both ends of the belt-shaped conductive foils 28a and 28b are connected to leads. Because of this, the number of used leads is totally six including 24a-24d, A and B.

Furthermore, to form this transformer, it is preferable to use the regulating member 36 shown in Fig. 10(B). With this arrangement, a transformer with a magnetic core can be easily and reliably formed.

Furthermore, the belt-shaped conductive foil 28c used as a portion of the transformer core in the abovedescribed transformer with the magnetic core is grounded at both ends thereof as shown in Fig. 10(C), so that noises can be reduced. Incidentally, the belt-shaped conductive foil 28c used in the above-described transformer core may be formed by use of a magnetic conductor or a plain conductor.

In the foregoing, the foil-reel electronic part and the process of producing the same according to the present invention have been described, however, the present invention need not necessarily be limited to the above-described embodiments, and, needless to say, the present invention is applicable widely to the various LC composite parts using the belt-shaped conductive foil or foils and yet having three or more leads.

For example, the belt-shaped conductive foil and the insulating film are not separately formed, and the belt-shaped conductive foil may be integrally formed on the outer surface of a belt-shaped dielectric such as a metallized paper.

## Claims

1. A foil-roll electronic part comprising:
at least three leads (24a to 24c),
at least one belt-shaped conductive foil (28,30) connected at one end to at least one lead (24a or 24b), the other end or intermediate portion of said conductive foil or foils being connected to at least one of the other leads (24c), and
at least two insulating films (32,34) interposed on or between said belt-shaped conductive foil or foils (28,30), whereby said belt-shaped conductive foil or foils (28,30) and said insulating films (32,34) are rolled as being a spool, to thereby form said foil-roll electronic part,
**characterized** in that
said leads (24a to 24c) are arranged in a lead frame (20) having a connecting member (22) to which the leads (24a to 24c) are connected, extending generally parallel to one another, with one of their ends, respectively.

2. A foil-roll electronic part as set forth in claim 1,
wherein said belt-shaped conductive foil (28,30) includes at least a belt-shaped conductive foil (30) for a grounding conductor which is connected at one end to at least one lead (24b) of said lead frame (20).

3. A foil-roll electronic part as set forth in claim 1 or 2,
wherein a bendable extension (26) for connection to the other end or the intermediate portion of the belt-shaped conductive foil (28) is provided on a given lead (24c) of said lead frame (20).

4. A foil-roll electronic part as set forth in anyone of claims 1 to 3,
wherein a regulating member (36) for regulating an interval or intervals between the leads (24a to 24c) of said lead frame is provided.

5. A foil-roll electronic part as set forth in claim 4,
wherein said regulating member (36) has grooves (38a to 38c) each having such a depth that said lead frame (20) does not protrude from the surface thereof.

6. A foil-roll electronic part as set forth in claim 4 or 5,
wherein said regulating member (36) is formed of a magnetic substance.

7. A foil-roll electronic part as set forth in anyone of claims 1 to 6,
wherein said belt-shaped conductive foils (28,30) are formed to provide a noise filter including at least two belt-shaped conductive foils (28,30), both ends of which are connected at both ends to different leads of said lead frame (20), whereby ends on one side of said two belt-shaped conductive foils (28,30) are formed to provide input terminals and ends on the other side are formed to provide output terminals.

8. A foil-roll electronic part as set forth in anyone of claims 1 to 7,
wherein a plurality of bendable extensions (26a, 26b) for connection at a plurality of positions to a belt-shaped conductor (30) for a grounding conductor are provided on a lead (24b) of said lead frame (20) for a grounding conductor.

9. A foil-roll electronic part as set forth in anyone of claims 1 to 8,
wherein said belt-shaped conductive foils (28,30) are formed to provide a transformer or a signal isolator including at least two belt-shaped conductive foils (28,30) for an electricity passing conductor which are connected at both ends to different leads (24a,24d) of said lead frame (20), whereby ends on one of said belt-shaped conductive foils (28,30) are formed to provide input terminals and ends on the other are formed to provide output terminals.

10. A foil-roll electronic part as set forth in anyone of claims 1 to 8,
wherein said belt-shaped conductive foils (28) are formed to provide a coil with an intermediate tap or an auto-transformer including a belt-shaped conductive foil for an electricity passing conductor which is connected at both ends or a given intermediate portion thereof to the leads (24a to 24c) of said lead frame (20).

11. A process of producing a foil-roll electronic part having at least three leads (24a to 24c), comprising the steps of:
Connecting one end of a belt-shaped conductive foil (28,30) to at least one of said leads (24a,24b) and
rolling said belt-shaped conductive foil or foils (28,30) as being a spool through an insulating film or films (32,34) in the above state,
**characterized** by
forming a lead frame (20) having said three leads (24a to 24c) connected with one of their ends to a connecting member (22),
engaging the leads (24a to 24c) of said lead frame (20) with a regulating member (26) subject to the connection and prior to the rolling step,
bending and connecting said extension or extensions (26a,26b) to a roll terminating end or the intermediate portion of said belt-shaped conductive foil or foils (28,30) and
cutting off the connection portions of the respective leads (24a to 24c).

12. A process as set forth in claim 11,
wherein the extension (26) originally is extending parallel to the respective lead (24c) and connected to the end thereof which is connected to said connecting member (22), said extension (26) being bent through a predetermined angle prior to the rolling step, said bent extension (26) being returned to substantially the original position subject to the rolling step.

## Patentansprüche

1. Elektronisches Rollenfolien-Bauelement mit:
wenigstens drei Leitungen (24a bis 24c),
wenigstens einer bandförmigen leitenden Folie (28, 30), die an einem Ende mit wenigstens einem Leiter (24a oder 24b) verbunden ist, wobei das andere Ende oder ein Zwischenabschnitt der leitenden Folie oder Folien mit wenigstens einem der anderen Leiter (24c) verbunden ist, und
wenigstens zwei isolierenden Filmen (32, 34), die auf oder zwischen der bandförmigen leitenden Folie oder Folien (28, 30) angeordnet sind, wodurch die bandförmige leitende Folie oder Folien (28, 30) und die isolierenden Filme (32, 34) in Gestalt einer Spule gerollt sind, um dadurch das Rollenfolien-Bauelement zu bilden,
dadurch **gekennzeichnet,**
daß die Leiter (24a bis 24c) in einem Leiterrahmen (20) angeordnet sind, der ein Anschlußteil (22) aufweist, an das die Leiter (24a bis 24c), allgemein parallel zueinander verlaufend, mit einem ihrer Enden angeschlossen sind.

2. Elektronisches Rollenfolien-Bauelement nach Anspruch 1,
wobei die bandförmige leitende Folie (28, 30) wenigstens eine bandförmige leitende Folie (30) für einen Erdungsstromleiter einschließt, der mit einem Ende an wenigstens einen Leiter (24d) des Leiterrahmens (20) angeschlossen ist.

3. Elektronisches Rollenfolien-Bauelement nach Anspruch 2,
wobei eine biegbare Verlängerung (26) zum Anschluß an das andere Ende oder den Zwischenabschnitt der bandförmigen leitenden Folie (28) an einem vorbestimmten Leiter (24c) des Leiterrahmens (20) vorgesehen ist.

4. Elektronisches Rollenfolien-Bauelement nach einem der Ansprüche 1 bis 3,
wobei ein Einstellteil (26) zum Einstellen eines Zwischenraums oder von Zwischenräumen zwischen den Leitern (24a bis 24c) des Leiterrahmens vorgesehen ist.

5. Elektronisches Rollenfolien-Bauelement nach Anspruch 4,
wobei das Einstellteil (36) Rillen (38a bis 38c) aufweist, von denen jede eine Tiefe derart hat, daß der Leiterrahmen (20) nicht über ihre Oberfläche übersteht.

6. Elektronisches Rollenfolien-Bauelement nach Anspruch 4 oder 5,
wobei das Einstellteil (36) aus einer magnetischen Substanz besteht.

7. Elektronisches Rollenfolien-Bauelement nach einem der Ansprüche 1 bis 6,
wobei die bandförmigen leitenden Folien (28, 30) als Störschutzfilter ausgebildet sind, das wenigstens zwei bandförmige leitende Folien (28, 30) einschließt, deren beide Enden an beiden Enden unterschiedlicher Leitungen des Leiterrahmens (20) angeschlossen sind, wodurch Enden auf einer Seite der beiden bandförmigen leitenden Folien (28, 30) Eingangsanschlüsse und Enden an der anderen Seite Ausgangsanschlüsse bilden.

8. Elektronisches Rollenfolien-Bauelement nach einem der Ansprüche 1 bis 7,
wobei eine Mehrzahl biegbarer Verlängerungen (26a, 26b) zum Anschluß an einer Mehrzahl von Positionen an einen bandförmigen Leiter (30) für einen Erdungsleiter an einem Leiter (24b) des Leiterrahmens (20) für einen elektrischen Erdungsleiter vorgesehen sind.

9. Elektronisches Rollenfolien-Bauelement nach einem der Ansprüche 1 bis 8,
wobei die bandförmigen leitenden Folien (28, 30) als Transformator- oder Signalisolator ausgebildet sind, der wenigstens zwei bandförmige leitende Folien (28, 30) für einen stromdurchlasssenden Leiter einschließt, die an beiden Enden an unterschiedliche Leiter (24a, 24d) des Leiterrahmens anschlossen sind, wodurch Enden an einer der bandförmigen leitenden Folien (28, 30) Eingangsanschlüsse und Enden an den anderen Enden Ausgangsanschlüsse bilden.

10. Elektronisches Rollenfolien-Bauelement nach einem der Ansprüche 1 bis 8,
wobei die bandförmigen leitenden Folien (28) als Spule mit einer Mittenanzapfung oder als Autotransformator ausgebildet sind, die bzw. der eine bandförmige leitende Folie für einen stromleitenden Leiter einschließt, der an beiden Enden oder einem vorgegebenen Zwischenabschnitt an die Leiter (24a bis 24c) des Leiterrahmens (20) angeschlosssen ist.

11. Verfahren zum Herstellen eines elektronischen Rollenfolien-Bauelements, das wenigstens drei Leiter (24a bis 24c) aufweist, mit den Schritten:
Verbinden eines Endes einer bandförmigen leitenden Folie (28, 30) mit wenigstens einem der Leiter (24a, 24b) und
Rollen der bandförmigen leitenden Folie oder der Folien (28, 30) in Gestalt einer Spule über einen isolierenden Film oder Filmen (32, 34) in den vorstehend genannten Zustand,
**gekennzeichnet**
durch Ausbilden eines Leiterrahmens (20), der die drei Leiter (24a bis 24c) aufweist, die mit einem ihrer Enden mit einem Anschlußteil (22) verbunden sind, in Eingriff bringen der Leiter (24a bis 24c) des Leiterrahmens (20) mit einem Einstellteil (36) nach dem Verbindungsschritt sowie vor dem Rollschritt, Biegen und Verbinden der Verlängerung oder der Verlängerungen (26a, 26b) zu einem Rollenabschlußende oder der des Zwischenabschnitts der bandförmigen leitenden Folie oder Folien (28, 30) und
Abschneiden der Verbindungsabschnitte der jeweiligen Leiter (24a bis 24c).

12. Verfahren nach Anspruch 11,
bei dem die Verlängerung (26) ursprünglich parallel zu dem jeweiligen Leiter (24c) verläuft und mit dessen Ende verbunden ist, das mit dem Anschlußteil (22) verbunden ist, wobei die Verlängerung (26) vor dem Rollschritt um einen vorbestimmten Winkel gebogen wird, wobei die gebogene Verlängerung (26) nach dem Rollschritt im wesentlichen in die ursprüngliche Position zurückgeführt wird.

## Revendications

1. Pièce électronique en rouleau de feuilles comprenant:
au moins trois conducteurs (24a à 24c),
au moins une feuille conductrice en forme de ruban (28, 30) branchée par une extrémité à au moins un conducteur (24a ou 24b), l'autre extrémité ou la partie intermédiaire de la feuille ou des feuilles conductrices étant branchée a l'un au moins des autres conducteurs (24c), et
au moins deux films isolants (32, 34) interposés sur ou entre la/les feuille(s) conductrice(s) en forme de ruban(28, 30), de façon que la ou les feuille(s) conductrice(s) en forme de ruban (28, 30) et les films isolants (32, 34) soient enroulés à la manière d'une bobine pour former ainsi la pièce électronique en rouleau de feuilles,
**caractérisée** en ce
que les conducteurs (24a à 24c) sont disposés dans une structure de conducteurs (20) munie d'un élément de connexion (22) auquel les conducteurs (24a à 24c) généralement disposés parallèlement les uns aux autressont connectés respectivement par l'une de leurs extrémités.

2. Pièce électronique en rouleau de feuilles selon la revendication 1,
**caractérisée** en ce
que la feuille conductrice en forme de ruban (28, 30) comprend au moins une feuille conductrice en forme de ruban (30) pour un conducteur de terre branché par une extrémité à au moins un conducteur (24b) de la structure de conducteurs (20).

3. Pièce électronique en rouleau de feuilles selon l'une quelconque des revendications 1 ou 2,
**caractérisée** en ce
qu'un prolongement pliable (26) de branchement à l'autre éxtrémite ou a la partie intermediaire de la feuille conductrice (28), est formé sur un conducteur donné (24c) de la structure de conducteurs (20).

4. Pièce électronique en rouleau de feuilles selon l'une quelconque des revendication 1 a 3,
**caractérisée** en ce
qu'un utilise un élément de réglage (36) pour régler un ou plusieurs intervalles entre les conducteurs (24a à 24c) de la structure de conducteurs.

5. Pièce électronique en rouleau de feuilles selon la revendication 4,
**caracterisee** en ce
que l'élément de réglage (36) comporte des rainures (38a à 38c) présentant chacune une profondeur telle que la structure des conducteurs (20) ne fasse pas saillie sur la surface de celles-ci.

6. Pièce électronique en rouleau de feuilles selon l'une quelconque des revendications 4 ou 5,
**caractérisée** en ce
que l'élément de réglage (36) est réalisé d'une substance magnétique.

7. Pièce électronique en rouleau de feuilles selon l'une quelconque des revendications 1 à 6,
**caractérisée** en ce
que les feuilles conductrices en forme de ruban (28, 30) sont utilisées pour former un filtre de bruit comprenant au moins deux feuilles conductrices en forme de ruban (28, 30) dont les deux extrémités sont branchées aux deux extrémités de conducteurs différents de la structure de conducteurs (20), de façon que les extrémités situées d'un côté des deux feuilles conductrices en forme de ruban (28, 30) soient utilisées pour former des bornes d'entrée, et que les extrémités situées de l'autre côté soient utilées pour former des bornes de sortie.

8. Pièce électronique en rouleau de feuilles selon l'un quelconque des revendication 1 à 7,
**caractérisée** en ce
qu'une pluralité de prolongements pliables (26a, 26b) à connecter à une pluralité de points à un conducteurs en forme de ruban (30) pour un conducteur de terre, sont formés sur un conducteur (24b) de la structure de conducteurs (20) pour un conducteur de terre.

9. Pièce électronique en rouleau de feuilles selon l'une quelconque des revendications 1 à 8,
**caractérisée** en ce
que les feuilles conductrices en forme de ruban (28, 30) sont utilisées pour former un transformateur ou un isolateur de signeaux comprenant au moins deux feuilles conductrices en forme de ruban (28, 30) pour un conducteur de passage d'électricité, ces feuilles conductrices étant branchés aux deux extrémités de conducteurs différents (24a, 24d) de la structure de conducteurs (20), de façon que des extrémités de l'une des feuilles conductrices en forme de ruban (28, 30) soient utilisées pour former des bornes d'entrée, et que les extrémités de l'autre feuille conductrice soient utilisées pour former des bornes de sortie.

10. Pièce électronique en rouleau de feuilles selon l'une quelconque des revendications 1 à 8,
**caractérisée** en ce
que les feuilles conductrices en forme de ruban (28) sont utilisées pour former une bobine munie d'une prise intermédiaire ou un autotransformateur comprenant une feuille conductrice en forme de ruban pour un conducteur de passage d'électricité branché par les deux extrémités ou par une partie intermédiaire donnée de celui-ci, aux conducteurs (24a à 24c) de la structure de conducteurs (20).

11. Procédé de fabrication d'une pièce électronique en rouleau de feuilles comportant au moins trois conducteurs (24a à 24c), ce procédé comprenant les étapes consistant à:
- brancher une extrémité d'une feuille conductrice en forme de ruban (28, 30) à l'un au moins des conducteurs (24a, 24b) et
- enrouler la feuille ou les feuilles conductrices en forme de ruban (28, 30) à la manière d'une bobine avec interposition d'un ou plusiers films isolants dans l'état ci-dessus, procédé
**caracatérisée** en ce
qu'il consiste à:
former une structure de conducteurs (20) comportant les trois conducteurs (24a à 24c) branchés par l'une de leurs extrémités à un élément de connexion (22),
engager les conducteurs (24a à 24c) de la structure de conducteurs (20) à un élément de réglage (26) après l'étape de connexion et avant l'étape d'enroulement,
courber et brancher le prolongement ou les prolongements (26a, 26b) à une extrémité de fin de rouleau ou à la partie intermédiaire de la feuille ou des feuilles conductrices en forme de ruban (28, 30), et
couper les parties de branchement des conducteurs resprectifs (24a à 24c).

12. Procédé selon la revendication 11,
**caractérisée** en ce
que le prolongement (26) est disposé initialement parallèlement au conducteur correspondent (24c) et branché à son extrémité reliée a l'élément de connexion (22), ce prolongement (26) étant courbé d'un angle prédétermine avant l'étape d'enroulement et ce prolongement courbé (26) étant ramené essentiellement à sa position initiale après l'étape d'enroulement.
